# FASCICULE DE BREVET EUROPEEN

(11) **EP 1 427 008 B1**
(45) Date de publication et mention de la délivrance du brevet: **23.04.2008**
(21) Numéro de dépôt: 03292810.3
(22) Date de dépôt: 10.11.2003
(51) Int. Cl.: H01L 21/60, H01L 21/603

(54) **Procédé de fabrication d'un module électronique comportant un composant actif sur une embase**
Herstellungsverfahren für einen elektronischen Modul mit einem aktiven Bauteil auf einem Substrat
Process of manufacturing an electronic module comprising an active component on a substrate

(30) Priorité: 05.12.2002 FR 0215331
(43) Date de publication de la demande: 09.06.2004
(73) Titulaire: Alcatel Lucent, 75008 Paris (FR)
(72) Inventeur: Giraudet, Louis, 51100 Reims (FR)
(74) Mandataire: Korakis-Ménager, Sophie

(56) Documents cités:
- DE-A- 4 226 167
- US-A- 5 478 778
- US-A1- 2002 071 642
- PATENT ABSTRACTS OF JAPAN vol. 2003, no. 03, 5 mai 2003 (2003-05-05) -& JP 2002 334902 A (HITACHI LTD), 22 novembre 2002 (2002-11-22)
- DEMIGUEL S ET AL: "Low-cost, polarisation independent, tapered photodiodes with bandwidth over 50 GHz" ELECTRONICS LETTERS, IEE STEVENAGE, GB, vol. 37, no. 8, 12 avril 2001 (2001-04-12), pages 516-518, XP006016458 ISSN: 0013-5194

## Description

L'invention se situe dans le domaine des dispositifs électroniques ou optoélectroniques destinés à fonctionner à très haute fréquence.

De tels dispositifs sont notamment utilisés dans les systèmes de transmission à haut débit, par exemple de l'ordre de 10 gigabits par seconde ou davantage. Beaucoup de ces dispositifs sont réalisés sous forme de modules qui nécessitent des montages de composants actifs, souvent monolithiques (puces), sur des embases (aussi appelées "substrat"). L'embase sert à la fois de support mécanique et d'interface électrique pour l'alimentation électrique du ou des composants actifs et pour leur appliquer ou en extraire des signaux électriques.

Par exemple, dans le cas des systèmes de transmission optique, les composants optoélectroniques concernés sont typiquement les modulateurs électro-optiques à électroabsorption, les photodétecteurs (photodiodes) ou encore les sources laser à commande de modulation directe. Sont également concernés les composants actifs purement électroniques, telles que les transistors ou circuits intégrés, utilisés dans les circuits électroniques hyperfréquence associés. Dans la suite, l'invention sera exposée en décrivant plus particulièrement le cas des photodiodes, bien qu'elle concerne également de nombreux autres types de composants et en particulier ceux mentionnés ci-dessus.

La fréquence maximale de fonctionnement de ces dispositifs est d'abord conditionnée par la technologie et la conception des composants utilisés. Mais elle dépend aussi grandement de la façon dont sont réalisées les interconnexions entre les composants et les embases sur lesquelles ils sont montés.

Un type de montage particulièrement performant de ce point de vue est le montage dit "flip-chip" selon lequel la totalité ou une partie des électrodes d'une puce constituant le composant sont disposés sur une même face pour pouvoir les connectées sans câblage à des plots ou zones de contact homologues de l'embase. Les électrodes de la puce ont la forme de plots et sont directement soudées sur les zones de contact de l'embase grâce à un matériau de soudage, par exemple un alliage or/étain AuSn recouvrant les zones de contact.

Le procédé permettant de réaliser un tel montage consiste au préalable à prévoir sur une face de la puce et sur une face de l'embase des plots et zones de contact homologues positionnés pour pouvoir se correspondre lorsque ces faces sont en vis-à-vis. Les zones de contact de l'embase comportent chacune à leur surface une quantité de matériau de soudage. En outre, les faces de la puce et de l'embase sont généralement munies de butées de positionnement horizontal permettant lors du montage de faire coïncider les plots et zones de contact homologues avec précision (méthode dite d'auto-alignement). On prévoit aussi des butées de positionnement vertical de la puce sur l'embase. Dans le cas des dispositifs optoélectroniques, il est important de réaliser ces butées avec précision en vue de permettre un bon couplage optique du composant avec d'autres éléments optiques montés ou s'appuyant sur l'embase.

Pour effectuer le montage, on place la puce de sorte que ses plots se trouvent en vis-à-vis respectivement avec les faces des zones de contact homologues de l'embase. On chauffe ensuite en une ou plusieurs fois l'ensemble à une température suffisante pour faire fondre le matériau de soudage qui vient mouiller en surface les plots de la puce. Par un choix approprié des matériaux de contact, des dimensions des zones de contact de l'embase et des plots de la puce, ainsi que des volumes de soudure, on fait en sorte que la fusion de la soudure crée en s'étalant une force résultante d'attraction entre la puce et l'embase. Une des conditions en particulier pour obtenir une force d'attraction entre un plot de la puce et une zone de contact de l'embase est que la surface du plot soit supérieure à celle de la zone.

Dans ces conditions, cette étape de fusion assure une mise en appui des butées de positionnement horizontal et vertical de la puce sur celles qui leur correspondent sur l'embase.

Ainsi, le placement, la fixation mécanique de la puce sur l'embase et les interconnections électriques entre la puce et l'embase sont effectués simultanément au cour de cette même étape de fusion.

Grâce à l'absence de câblage, la fréquence de coupure d'un module obtenu par le montage "flip-chip" rappelé ci-dessus est limitée principalement par sa capacité équivalente. Dans le cas des photodiodes par exemple, cette technique a permis de réaliser des modules ayant une fréquence de coupure supérieure à 10 GHz et donc pouvant détecter un signal dont le débit est de 10 Gbit/s.

En vue d'atteindre des débits encore plus élevés, on sait réaliser des photodiodes capables de fonctionner au delà de 40 Gbit/s, grâce à des structures présentant une faible capacité intrinsèque. Pour cela, on est conduit à diminuer la surface de la partie active ainsi que celle d'au moins une des électrodes par lesquelles transite le signal électrique modulé. Pour un dimensionnement optimal, il convient que cette électrode aient des dimensions analogues à celles de la partie active. Cette dernière observation est également valable pour tout type de composant destiné à fonctionner à très haute fréquence.

Ainsi, dans le cas d'une photodiode, un fonctionnement à 40 Gbit/s impose une surface active et donc une surface d'électrode qui ne dépasse pas 100 µm². Or, avec le procédé de montage "flip-chip" décrit ci-dessus utilisant une fusion de soudure, les dimensions des plots de contact sur la puce et des zones de contact sur l'embase sont difficilement inférieures à 30 µm environ. De plus, une surface réduite des plots et des zones de contact implique une force d'attraction limitée entre la puce et l'embase. Ce procédé n'est donc pas adapté au montage de composants munis de très petites électrodes compatibles avec des fonctionnements à des fréquences nettement supérieures à 10 GHz.

Pour échapper à cette limitation, on peut envisager d'utiliser d'autres procédés qui permettent de souder des surfaces d'électrodes plus faibles.

C'est le cas en particulier du procédé de soudage par thermocompression. Dans son principe, ce procédé permet de souder des éléments métalliques de compositions appropriées en réalisant une diffusion métal-métal par une mise en contact prolongée et sous pression de ces éléments à une température relativement élevée, mais inférieure à la température de fusion des métaux ou alliages utilisés. L'absence de fusion autorise la formation de points de contact particulièrement petits et de dimensions bien contrôlables. Le métal le plus adapté au soudage par thermocompression est l'or, mais d'autre métaux sont utilisables, par exemple l'aluminium, le cuivre, ainsi que des alliages de ces métaux.

Pour réaliser l'assemblage d'une puce sur une embase par thermocompression, tout en restant dans la configuration flip-chip décrite précédemment, on devra d'abord prévoir sur l'ensemble des plots de la puce et des zones de contact de l'embase des couches métalliques de compositions adaptées à ce procédé, typiquement en or. Il faut ensuite placer la puce sur l'embase en mettant en contact les couches métalliques de la puce avec les couches homologues de l'embase. Puis, on doit chauffer l'ensemble tout en appliquant pendant une durée déterminée une force pour comprimer les couches métalliques des plots de la puce sur les couches homologues de l'embase.

Par rapport au procédé classique, le procédé par thermocompression qui vient d'être envisagé présente toutefois les inconvénients qu'il ne permet pas de bénéficier des avantages de l'auto-alignement et que le montage résultant possède une résistance mécanique limitée.

L'invention a pour but à la fois de remédier aux limitations de fréquence de fonctionnement inhérentes au procédé de montage "flip-chip" par soudage classique et d'échapper aux inconvénients du procédé par thermocompression.

Dans ce but, l'invention a pour objet un procédé de fabrication d'un module électronique ou optoélectronique comportant un composant actif monté sur une embase, une face du composant étant munie de plusieurs plots de contact prévus pour coopérer avec des zones de contact correspondantes disposées sur une face de l'embase, au moins un plot du composant ayant une première structure verticale de plot étant prévu pour être soudé au moyen d'un premier matériau de soudage à une zone de contact correspondante de l'embase ayant une première structure verticale de zone de contact, caractérisé en ce qu'il consiste :
- à concevoir ledit composant et ladite embase de sorte qu'au moins un autre plot du composant ayant une fonction électrique ait une seconde structure verticale de plot et soit prévu pour être soudé à une zone de contact correspondante de l'embase ayant une seconde structure verticale de zone de contact, les plot(s) et zone(s) ayant respectivement lesdites secondes structures de plot et de zone étant revêtus respectivement de seconds matériaux de soudage ayant chacun une température de fusion supérieure à celle du premier matériau de soudage, ces seconds matériaux étant aptes à être directement soudés ensemble par thermocompression à une température d'assemblage comprise entre la température de fusion du premier matériau de soudage et celle des seconds matériaux de soudage, les plot(s) et zone(s) de contact ayant respectivement les premières structures de plot et de zone ayant des dimensions telles que leur(s) soudage(s) par fusion dudit premier matériau de soudage à ladite température d'assemblage produise une force résultante d'attraction réciproque entre le composant et l'embase qui assure ledit soudage par thermocompression des plot(s) et zone(s) de contact ayant respectivement les secondes structures de plot et de zone,
- à mettre en appui le composant sur l' embase en plaçant en vis-à-vis respectivement lesdits plots et lesdites zones correspondantes, et
- à chauffer le composant et l'embase à ladite température d'assemblage.

Ainsi, l'invention tire profit de l'observation que la valeur minimale de pression à exercer pour effectuer le soudage par thermocompression d'une partie des zones de contact de l'embase et de plots homologues du composant nécessite en fait une force résultante qui peut être aisément dépassée par la résultante de forces d'attraction que d'autre zones de contact de l'embase munies de soudure peuvent exercer sur des plots homologues du composant.

On peut remarquer que les plots et zones de contact prévus pour être soudés par thermocompression ont normalement une fonction électrique, mais ils ont aussi une fonction de positionnement vertical du composant par rapport à l'embase. Aussi, pour certains composants munis d'au moins trois plots à souder par thermocompression, il est possible que ces plots suffisent pour réaliser le positionnement vertical. Si par contre leur nombre est insuffisant, des buttées supplémentaires de positionnement devront être prévues. Dans ce cas, il est avantageux que ces buttées aient la même structure que celle des plots servant aux contacts électriques car les plots à fonction électrique et des plots à fonction purement mécanique peuvent être réalisés au cours d'étapes communes de fabrication du composant. Il en est de même pour les zones de contact homologues de l'embase.

Aussi, selon un mode de réalisation particulièrement adapté aux cas où le nombre de plots du composant ayant une fonction électrique est petit, au moins un autre plot et une autre zone de contact correspondante ayant respectivement les secondes structures de plot et de zone ont seulement une fonction de positionnement du composant par rapport à l'embase.

Dans ce cas, les plots ayant la seconde structure de plot présentent avantageusement une surface de contact identique. Cette dernière disposition permet en effet d'éviter des différences de comportements mécaniques selon les plots et zones de contact lors de leurs soudages. Il en résulte une meilleure stabilité du composant par rapport à l'embase et un risque moindre d'appliquer à la puce des contraintes.

Généralement, pour obtenir une faible capacité, il n'est pas nécessaire que toutes les électrodes d'un composant aient de faibles surfaces. Par exemple, dans le cas d'une photodiode de type p-i-n à structure "ridge", une faible capacité impose une faible surface de la couche active qui impose celle du "ridge". Mais pour conserver une faible capacité après l'ajout des électrodes, il suffit que seule l'électrode surmontant la partie "ridge" soit de dimensions analogues à cette partie. Les autres électrodes pouvant être de plus grandes dimensions, elles peuvent être soudées de façon classique, c'est-à-dire au moyen du premier matériau de soudage. Dans certains cas, il sera donc possible de mettre en oeuvre le procédé selon l'invention au moyen de plots et de zones de contact correspondantes ayant respectivement les premières structures de plot et de zone, ces plots et zones ayant chacun une fonction électrique.

Dans les autres cas, et selon un mode particulier de réalisation selon l'invention, on prévoira qu'au moins un plot et une zone de contact correspondante ayant respectivement les premières structures de plot et de zone ont seulement une fonction d'attraction réciproque entre le composant et l'embase.

L'invention concerne aussi un module électronique ou optoélectronique obtenu par le procédé défini ci-dessus.

Plus précisément, l'invention a aussi pour objet un module électronique ou optoélectronique comportant un composant actif monté sur une embase, une face du composant étant munie de plusieurs plots de contact coopérant avec des zones de contact correspondantes disposées sur une face de l'embase, au moins un plot du composant ayant une première structure verticale de plot étant soudé au moyen d'un premier matériau de soudage à une zone de contact correspondante de l'embase ayant une première structure verticale de zone de contact, caractérisé en ce qu'au moins un autre plot du composant ayant une fonction électrique a une seconde structure verticale de plot et est soudé à une zone de contact correspondante de l'embase ayant une seconde structure verticale de zone de contact, les plot(s) et zone(s) ayant respectivement lesdites secondes structures de plot et de zone étant revêtus respectivement de seconds matériaux de soudage ayant chacun une température de fusion supérieure à celle du premier matériau de soudage, ces seconds matériaux étant aptes à être directement soudés ensemble par thermocompression à une température d'assemblage comprise entre la température de fusion du premier matériau de soudage et celle des seconds matériaux de soudage, les plot(s) et zone(s) de contact ayant respectivement les premières structures de plot et de zone ayant des dimensions telles que leur(s) soudage(s) par fusion dudit premier matériau de soudage à ladite température d'assemblage produise une force résultante d'attraction réciproque entre le composant et l'embase qui assure ledit soudage par thermocompression des plot(s) et zone(s) de contact ayant respectivement les secondes structures de plot et de zone.

D'autres aspects et avantages de l'invention apparaîtront dans la suite de la description en référence aux figures.
- La figure 1 représente schématiquement un exemple de composant disposé au dessus d'une embase avant leur assemblage, conformément au procédé selon l'invention.
- La figure 2 représente schématiquement les structures verticales des zones et plots de contact du composant et de l'embase de la figure 1.
- La figure 3 représente les mêmes éléments après assemblage , conformément au procédé selon l'invention.

Le procédé selon l'invention sera illustré dans le cas particulier où le composant est une photodiode à haut débit. Pour des raisons de clarté, les proportions des dimensions n'ont pas été respectées sur les figures, mais des valeurs de dimensions réelles applicables à cet exemple seront indiquées à la fin de la présente description.

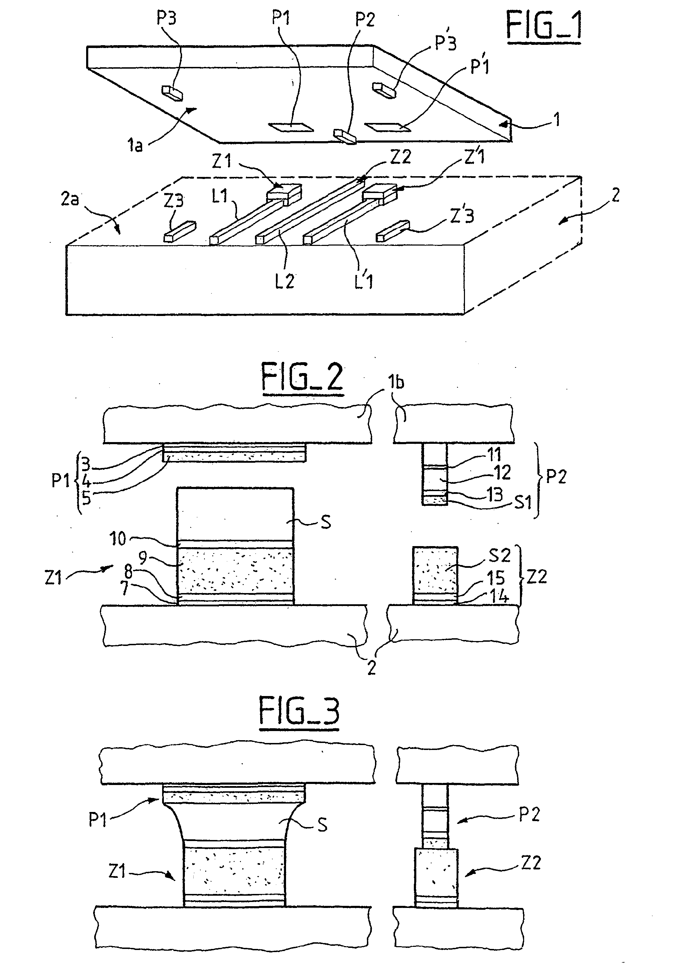

La figure 1 montre schématiquement en perspective cavalière la photodiode 1 placé au dessus d'une partie d'embase 2 avant assemblage pour former un module.

La face 1a de la photodiode 1 est placée en vis-à-vis de la face 2a de l'embase et on distingue la disposition des différents plots et zones de contact impliqués dans le procédé selon l'invention. La figure 2 montre plus en détail leurs structures. Selon une convention habituelle pour décrire les différentes structures impliquées, la direction dite "verticale" désignera la direction perpendiculaire aux couches épitaxiales du composant et aux faces 1a et 2a du composant et de l'embase supposées parallèles.

La photodiode 1 est par exemple réalisée sur un substrat en InP avec une couche épitaxiale 1b en InP dopé n sur laquelle est formée une structure active p-i-n classique délimitée dans une partie en saillie, habituellement appelée "ridge". Comme montré sur la figure 2, la structure p-i-n est formée essentiellement de la couche 1b, d'une couche active 11 et d'une couche 12 en InP dopé p.

Les connexions électriques sont réalisées au moyen de deux plots P1, P'1 placées sur la couche 1b de part et d'autre du "ridge", et d'une électrode placée sur la couche 12 du "ridge". Cette dernière est constituée de couches de métallisation 13, S1, respectivement en platine et en or par exemple. Les plots P1, P'1 sont formés sur la couche 1b successivement d'une couche de titane 3, d'une couche de platine 4 et d'une couche d'or 5.

Les couches 3, 4, 5 des plots P1, P'1 constituent une première structure verticale de plot prévue pour un soudage par fusion de soudure. Le "ridge" recouvert des couches 13 et S1 constitue un autre plot désigné par P2, ayant une seconde structure verticale de plot prévue pour un soudage par thermocompression.

Comme la photodiode 1 ne possède qu'un seul plot P2 ayant une fonction électrique et destiné à un soudage par thermocompression, on a prévu deux plots supplémentaires P3, P'3 pour servir de buttées de positionnement vertical. Les plots P3, P'3 ont la même structure verticale et les mêmes dimensions horizontales que le plot P2, mais ils n'ont pas de fonction électrique. Ainsi, les trois plots P2, P3, P'3, constituent trois butées disposées en triangle qui vont assurer la stabilité du composant sur l'embase.

L'embase 2 est par exemple constituée d'un matériau isolant tel que l'alumine. Sa face 2a est munie de zones de contact Z1, Z'1, Z2, Z3, Z'3 correspondant respectivement aux plots P1, P'1, P2, P3, P'3 du composant 1. Ces zones de contact sont disposées pour se trouver en vis-à-vis respectivement des plots homologues du composant lorsque la face 1a du composant est appliquée sur la face 2a de l'embase.

Les zones de contact peuvent avoir une première ou une seconde structure verticale correspondant respectivement à la première ou seconde structure verticale de plot décrite précédemment.

La première structure verticale est celle de la zone de contact Z1 montrée sur la figure 2. Les zones Z1 et Z'1 ont des structures identiques et sont prévues pour être soudées respectivement aux plots P1 et P'1 par fusion de soudure.

Selon l'exemple représenté, les zones de contact Z1 et Z'1 sont, à partir de l'embase 2, formées successivement d'une couche de titane 7, d'une couche de platine 8, d'une couche d'or 9, d'une seconde couche de titane 10 et d'une couche S en un alliage à base d'or et d'étain.

La seconde structure verticale montrée sur la figure 2 est celle de la zone de contact Z2. Les zones Z2, Z3, Z'3 ont des structures identiques et sont prévues pour être soudées respectivement aux plots P2, P3, P'3 par thermocompression.

Selon l'exemple représenté, les zones de contact Z2, Z3, Z'3 sont, à partir de l'embase 2, formées successivement d'une couche de titane 14, d'une couche de platine 15 et d'une couche d'or S2. Ces trois couches 14, 15, S2 définissant la seconde structure verticale de zone sont avantageusement les mêmes en compositions et épaisseurs respectivement que les trois premières couches 7, 8, 9 de la première structure, de façon à pouvoir être déposée au cours d'étapes de fabrication communes aux deux structures.

Les zones Z1, Z'1 , Z2 de l'embase qui correspondent respectivement aux plots P1, P'1 et P2 ont une fonction électrique et sont par conséquent reliés respectivement à trois lignes électriques L1, L'1 et L2 disposées sur l'embase, comme on peut le voir sur la figure 1. La structure verticale de ces lignes est avantageusement identique à celle de la seconde structure des zones Z2, Z3, Z'3 car elles pourrons être déposées au cours d'étapes de fabrication communes.

Les épaisseurs des différentes couches énumérées ci-dessus seront choisies selon les critères suivants. Les couches en titane ou en platine sont des couches d'antidiffusion et d'accrochage habituelles, de faibles épaisseurs, typiquement entre 0,05 et 0,2 µm. La couche S1 aura une épaisseur suffisante, par exemple de 0,25 µm, pour permettre la thermocompression. Les épaisseurs des couches 5, 9, et S seront alors déterminées pour que les faces des plots et des zones homologues puissent entrer en contact lors de l'étape de fusion de la couche S.

Concernant les dimensions horizontales, celles du plot P2 sont fixées par celles du "ridge" de la photodiode qui sont elles-mêmes conditionnées par la fréquence de coupure intrinsèque visée. Par exemple, pour un fonctionnement à 40 Gbit/s, on aura une longueur de ridge (dans la direction de propagation des ondes dans la structure) de l'ordre de 20 µm, pour une largeur de l'ordre de 5 µm. Pour assurer une tolérance de positionnement, les dimensions horizontales de la zone Z2 seront choisies légèrement supérieures à celles du "ridge". On pourra adopter les mêmes dimensions horizontales pour les autres plots et zones de contact ayant respectivement les secondes structures de plot et de zone.

Les dimensions horizontales des plots P1, P'1 et zones de contact Z1, Z'1 ayant respectivement les premières structures de plot et de zone doivent suivre les règles suivantes. La surface de chaque plot doit d'abord être supérieure à celle de la zone homologue de façon à ce qu'il y ait attraction réciproque lors de la fusion de la soudure les joignant. Ensuite, il faut que les surfaces des plots et des zones, et/ou leurs nombres soient suffisants pour créer une force résultante d'attraction entre le composant et l'embase qui assure le soudage des autres plots et zones de contact par thermocompression.

Ainsi, dans l'exemple de la photodiode munie d'un ridge de 100 µm², on pourra prévoir des zones de contact Z1 de forme carrées avec des côtés longs de 100 µm et des plots P1 également carrés avec des côtés longs de 150 µm.

Le procédé de fabrication selon l'invention se termine par l'opération d'assemblage. Elle consiste à mettre en appui le composant 1 sur l'embase 2 en plaçant en vis-à-vis respectivement les plots et les zones correspondantes, et à chauffer le composant et l'embase à une température d'assemblage comprise entre la température de fusion du matériau de soudage S, c'est-à-dire de l'alliage or/étain et celle des autres matériaux de soudage S1, S2, c'est-à-dire de l'or.

La fusion de l'alliage or/étain se produisant à 280°C et l'or fondant à plus de 1000°C, on pourra choisir une température d'assemblage de l'ordre de 340°C.

Ainsi, en chauffant l'ensemble à cette température, la soudure S va fondre et mouiller toute la surface de la couche 5 en prenant une forme évasée comme représenté sur la figure 3, tout en exerçant une force d'attraction entre le plot P1 et la zone Z1.

Le cas de la photodiode qui vient d'être décrit n'est bien sûr qu'un exemple d'application du procédé selon l'invention. L'invention peut aussi s'appliquer à de nombreux autres types de composants, et en particulier ceux destinés à fonctionner à très haute fréquence et qui par conséquent nécessitent au moins une électrode de faible surface.

Typiquement, pour une photodiode devant fonctionner à 10 Gbit/s le plot P2 ayant la seconde structure de plot devra présenter une surface de contact inférieure à 1000 µm² environ. Pour des débits à partir de 40 Gbit/s, cette surface de contact devra être inférieure à 150 µm² environ.

De même, les matériaux constitutifs des couches formant les plots et zones de contact sont des exemples non limitatifs de mise en oeuvre de l'invention.

D'une façon générale, dans le procédé selon l'invention, il importe seulement que le matériau constituant la couche S puisse constituer un premier matériau de soudage dont la température de fusion est inférieure à celles des matériaux constituant les couches S1 et S2. D'autre part, ces derniers constituent des seconds matériaux de soudage qui doivent être choisi pour pouvoir être directement soudés ensemble par thermocompression à une température d'assemblage comprise entre la température de fusion du premier matériau de soudage S et celle des seconds matériaux de soudage S1, S2. Le choix d'un alliage à base d'or et d'étain pour le premier matériau de soudage et de l'or pour les seconds répond bien aux conditions.

## Revendications

1. Procédé de fabrication d'un module électronique ou optoélectronique comportant un composant actif (1) monté sur une embase (2), une face (1a) du composant étant munie de plusieurs plots de contact (P1, P'1, P2, P3, P'3) prévus pour coopérer avec des zones de contact correspondantes (Z1, Z'1, Z2, Z3, Z'3) disposées sur une face (2a) de l'embase, au moins un plot (P1, P'1) du composant ayant une première structure verticale de plot étant prévu pour être soudé au moyen d'un premier matériau de soudage (S) à une zone de contact correspondante (Z1, Z'1) de l'embase ayant une première structure verticale de zone de contact, **caractérisé en ce qu**'il consiste :
- à concevoir ledit composant et ladite embase de sorte qu'au moins un autre plot (P2) du composant ayant une fonction électrique ait une seconde structure verticale de plot et soit prévu pour être soudé à une zone de contact correspondante (Z2) de l'embase ayant une seconde structure verticale de zone de contact, les plot(s) et zone(s) (P2, Z2) ayant respectivement lesdites secondes structures de plot et de zone étant revêtus respectivement de seconds matériaux de soudage (S1, S2) ayant chacun une température de fusion supérieure à celle du premier matériau de soudage, ces seconds matériaux étant aptes à être directement soudés ensemble par thermocompression à une température d'assemblage comprise entre la température de fusion du premier matériau de soudage (S) et celle des seconds matériaux de soudage (S1, S2), les plot (s) et zone (s) de contact (P1, Z1) ayant respectivement les premières structures de plot et de zone ayant des dimensions telles que leur(s) soudage(s) par fusion dudit premier matériau de soudage à ladite température d'assemblage produise une force résultante d'attraction réciproque entre le composant et l'embase qui assure ledit soudage par thermocompression des plot(s) et zone(s) de contact (P2, Z2) ayant respectivement les secondes structures de plot et de zone,
- à mettre en appui le composant sur l' embase en plaçant en vis-à-vis respectivement lesdits plots et lesdites zones correspondantes, et
- à chauffer le composant et l'embase à ladite température d'assemblage.

2. Procédé selon la revendication 1, **caractérisé en ce qu**'au moins un autre plot (P3, P'3) et une autre zone de contact correspondante (Z3, z'3) ayant respectivement les secondes structures de plot et de zone ont seulement une fonction de positionnement du composant par rapport à l'embase.

3. Procédé selon la revendication 2, **caractérisé en ce que** les plots (P2, P3, P'3) ayant ladite seconde structure de plot présentent une surface de contact identique.

4. Procédé selon l'une des revendications 1 à 3, **caractérisé en ce qu**'au moins un plot et une zone de contact correspondante ayant respectivement les premières structures de plot et de zone ont seulement une fonction d'attraction réciproque entre le composant et l'embase.

5. Procédé selon l'une des revendications 1 à 4, **caractérisé en ce que** ledit premier matériau de soudage est un alliage à base d'or et d'étain.

6. Procédé selon l'une des revendications 1 à 5, **caractérisé en ce que** lesdits seconds matériaux de soudage (S1, S2) sont chacun l'or.

7. Procédé d'assemblage selon l'une des revendications 1 à 6, **caractérisé en ce que** ledit plot (P2) ayant ladite seconde structure de plot du composant présente une surface de contact inférieure à 1000 µm².

8. Procédé d'assemblage selon la revendication 7, **caractérisé en ce que** ledit plot (P2) ayant ladite seconde structure de plot du composant présente une surface de contact inférieure à 150 µm².

9. Module électronique ou optoélectronique comportant un composant actif (1) monté sur une embase (2), une face (1a) du composant étant munie de plusieurs plots de contact (P1, P'1, P2, P3, P'3) coopérant avec des zones de contact correspondantes (Z1, Z'1, Z2, Z3, Z'3) disposées sur une face (2a) de l'embase, au moins un plot (P1, P'1) du composant ayant une première structure verticale de plot étant soudé au moyen d'un premier matériau de soudage (S) à une zone de contact correspondante (Z1, Z'1) de l'embase ayant une première structure verticale de zone de contact, **caractérisé en ce qu**'au moins un autre plot (P2) du composant ayant une fonction électrique a une seconde structure verticale de plot et est soudé à une zone de contact correspondante (Z2) de l'embase ayant une seconde structure verticale de zone de contact, les plot(s) et zone(s) (P2, Z2) ayant respectivement lesdites secondes structures de plot et de zone étant revêtus respectivement de seconds matériaux de soudage (S1, S2) ayant chacun une température de fusion supérieure à celle du premier matériau de soudage, ces seconds matériaux étant aptes à être directement soudés ensemble par thermocompression à une température d'assemblage comprise entre la température de fusion du premier matériau de soudage (S) et celle des seconds matériaux de soudage (S1, S2), les plot(s) et zone(s) de contact (P1, Z1) ayant respectivement les premières structures de plot et de zone ayant des dimensions telles que leur(s) soudage(s) par fusion dudit premier matériau de soudage à ladite température d'assemblage produise une force résultante d'attraction réciproque entre le composant et l'embase qui assure ledit soudage par thermocompression des plot(s) et zone(s) de contact (P2, Z2) ayant respectivement les secondes structures de plot et de zone.

10. Module selon la revendication 9, **caractérisé en ce que** ledit composant actif (1) est un composant optoélectronique du type photodiode, ou modulateur électro-optique à électroabsorption, ou source laser à commande de modulation directe.

## Claims

1. A method for manufacturing an electronic or optoelectronic module comprising an active component (1) mounted onto a substrate (2), with one face of the component being equipped with multiple pads (P1, P'1, P2, P3,P'3) designed to cooperate with corresponding contact areas (21, Z'1, Z2, Z3, Z'3) arranged on one face (2a) of the substrate, and with at least one pad (P1, P'1) on the component having a first vertical contact pad structure designed to be bonded using a first bonding material (S) to a corresponding contactarea(Z1 ,Z'1) on the substrate that has a first vertical contact area structure, this method being **characterized by** the fact that it includes:
- designing said component and substrate so that at least one other pad (P2) on the component with an electrical function has a second vertical pad structure, and is deigned to be soldered onto a corresponding contact area (22') on the substrate that has a second vertical contact area structure, the pad(s) and area(s ) (P2, Z2) having respectively said second pad and contact area structures being covered, respectively, with second bonding materials (S1, S2) each having a melting point higher than that of the first bonding material, these second bonding materials being suitable for being directly soldered together by thermocompression at an assembly temperature between the melting point of the first (S) bonding material and second (S1, S2) bonding material, the pad(s) and contact area(s) (P1, 21) having respectively the first pad and contact area structures having dimensions such that the soldering of said first bonding material melting at said assembly temperature, produces a resulting mutual attraction force between the component and the substrate, said force ensuring said thermocompression soldering of the pad(s) and contact area(s) (P2, Z2) having the second pad and contact area structures,
- supporting the component on the substrate by bringing said pads and said corresponding areas face to face,
- heating the component and the substrate to said assembly temperature.

2. A method according to claim 1, **characterized by** the fact that at least one other pad (P3, P'3) and one other corresponding contact area (Z3, Z'3) having, respectively, the second pad and contact area structures, only have the function of positioning the component vertical with respect to the substrate.

3. A method according to claim 2, **characterized by** the fact that the pads (P2, P3, P'3) with said second vertical pad structure have identical contact surface areas.

4. A method according to any one of claims 1 to 3, **characterized by** the fact that at least one pad and one corresponding contact area respectively having the first vertical pad and first contact area structures only have the function of providing a mutual attraction between the component and the substrate,

5. A method according to one of claims 1 to 4, **characterized by** the fact that said first bonding material is a gold/tin alloy.

6. A method according to one of claims 1 to 5, **characterized by** the fact that said second bonding material (S1, S2) are each made of gold.

7. An assembly method according to one of claims 1 to 6, **characterized by** the fact that said component pad (P2) with said second vertical pad structure has a contact surface area lower than 1000 *µ*m2 .

8. An assembly method according to claim 7, **characterized by** the fact that said pad (P2) having said second component vertical pad structure has a contact surface area lower than 150 *µ*m2.

9. An electronic or optoelectronic module comprising an active component (1) mounted on a substrate (2), with one face (1a) of the component being equipped with a plurality of pads (P1, P'1, P2, P3, P'3) cooperating with corresponding contact areas (Z1, Z' 1, Z2, Z3, Z'3) arranged on one face (2a) of the substrate, and at least one of the component's pads (P1, P'1) with a first vertical pad structure being bonded using a first bonding material (S) to a corresponding contact area (Z1, Z'1) on the substrate with a first vertical contact area structure, the module being **characterized in that** at least one other pad (P2) on the component with an electrical function has a second vertical pad structure and is bonded to a corresponding contact area (Z2) on the substrate with a second vertical contact area structure, the pad(s) and the contact area(s) (P2, Z2) respectively having said second vertical pad and contact area structures being coated with respective second bonding matetials(S1, S2), each having a melting point higher than the melting point of the first bonding material, the second materials being suitable for being bonded together directly by thermal compression at an assembly temperature comprised between the melting point of the first bonding material (S) and the melting points of the second bonding materials (S1, S2), with the pad(s) and the contact area(s) (P1, Z1) respectively having the first vertical pad and contact area structures having dimensions such that, the soldering of said first bonding material melting at said assembly temperature, produces a resulting mutual force of attraction between the component and the substrate, which ensures said thermocompression soldering of the pad(s) and the contact area(s)(P2, Z2) having respectively the second vertical pad and contact area structures.

10. A module according to claim 9, **characterized by** the fact that said active component (1) is an optoelectronic component of the photodiode type, or an electroabsorption electrooptical modulator, or a laser source with direct modulation control.

## Patentansprüche

1. Herstellungsverfahren für ein elektronisches oder optoelektronisches Modul mit einem auf einem Substrat (2) befestigten aktiven Bauteil (1), wobei eine Seite (1a) des Bauteils mit mehreren Kontaktanschlussflächen (P1, P'1. P2, P3, P'3) ausgestattet ist, welche dafür vorgesehen sind, mit entsprechenden Kontaktzonen (Z1, Z'1, Z2, Z3, Z'3) zusammenzuwirken, die auf einer Seite (2a) des Substrats angeordnet sind, wobei mindestens eine Anschlussfläche (P1, P'1) des Bauteils eine erste vertikale Anschlussflächenstruktur aufweist, welche dafür vorgesehen ist, mittels eines ersten Lotmaterials (S) auf eine entsprechende Kontaktzone (Z1, Z'1) des Substrats gelötet zu werden, welche eine erste vertikale Struktur der Kontaktzone aufweist, **dadurch gekennzeichnet, dass** es darin besteht:
- das Bauteil und das Substrat derart zu gestalten, das mindestens eine weitere Anschlussfläche (P2) des Bauteils mit einer elektrischen Funktion eine zweite vertikale AnschlLissflächenstruktur aufweist und dafür vorgesehen ist, mit einer entsprechenden Kontaktzone (Z2) des Substrats mit einer zweiten vertikalen Kontaktzonenstruktur gebondet zu werden, wobei die Anschlossfläche(n) und Zone(n) (P2, Z2), die jeweils diese zweiten Anschlussflächen- und Zonenstrukturen aufweisen, jeweils von zweiten Lotmaterialien (S1, S2) überzogen sind, von denen jedes eine höhere Schmelztemperatur aufweist als diejenige des ersten Lotmaterials, wobei diese zweiten Materialien dazu geeignet sind, direkt durch Thermokompression bei einer Fügetemperatur gebondet zu werden, die zwischen der Schmelztemperatur des ersten Lotmaterials (S) und derjenigen der zweiten Lotmaterialien (S1, S2) liegt, wobei die Anschlussfläche(n) und Kontaktzonen (P1, Z1), die jeweils die ersten Anschlussflächen- und Zonenstrukturen aufweisen, Abmessungen von der Art aufweisen, dass ihr(e) Lötung(en) durch Schmelzen des ersten Lotmaterials mit der genannten Fügetemperatur eine resultierende gegenseitige Anziehungskraft zwischen dem Bauteil und dem Substrat erzeugt (erzeugen), welche das Thermokompressionsbonden der Anschlussfläche(n) und Kontaktzone(n) (P2, Z2) sicherstellt, die jeweils die zweiten Anschlussflächen- und Kontaktzonen aufweisen:
- das Bauteil auf dem Substrat in Anlage zu bringen, indem die Anschlussflächen und entsprechenden Zonen jeweils einander gegenüberliegend platziert werden; und
- das Bauteil und das Substrat auf die Fügetemperatur zu erhitzen.

2. Verfahren nach Anspruch 1, **dadurch gekennzeichnet, dass** mindestens eine weitere Anschlussfläche (P3, P'3) und eine weitere entsprechende Kontaktzone (Z3, Z'3), die jeweils die zweiten Anschlussflächen- und Zonenstrukturen aufweisen, nur eine Funktion der Positionierung des Bauteils gegenüber dem Substrat besitzen.

3. Verfahren nach Anspruch 2, **dadurch gekennzeichnet, dass** die Anschlussflächen (P2, P3, P'3) mit der zweiten Anschlussflächenstruktur vorteilhaftervveise eine identische Kontaktfläche aufweisen.

4. Verfahren nach einem der Anspruche 1 bis 3, **dadurch gekennzeichnet, dass** mindestens eine Anschlussfläche und eine entsprechende Kontaktzone, die jeweils die ersten Anschlussflächen- und Zonenstrukturen aufweisen, nur eine Funktion der gegenseitigen Ansehung zwischen dem Bauteil und dem Substrat innehaben.

5. Verfahren nach einem der Ansprüche 1 bis 4, **dadurch gekennzeichnet, dass** das erste Lotmaterial eine Legierung auf der Basis von Gold und Zinn ist.

6. Verfahren nach einem der Ansprüche 1 bis 5, **dadurch gekennzeichnet, dass** die zweiten Lotmaterialien (S1, S2) jeweils Gold sind.

7. Fügeverfahren nach einem der Ansprüche 1 bis 6, **dadurch gekennzeichnet, dass** die Anschlussfläche (P2) mit der zweiten Anschlussflächenstruktur des Bauteils eine Kontaktoberfläche von weniger als 1000 µm² aufweist.

8. Fügeverfahren nach Anspruch 7, **dadurch gekennzeichnet, dass** die Anschlussfläche (P2) mit der zweiten Anschlussflächenstruktur des Bauteils eine Kontaktoberfläche von weniger als 1000 µm² aufweist.

9. Elektronisches oder optoelekztronisches Modul mit einem auf einem Substrat (2) montierten aktiven Bauteil (1), wobei eine Seite (1a) des Bauteils mit mehreren Kontaktanschlussflachen (P1, P'1, P2, P3, P'3) ausgestattet ist, die mit entsprechenden Kontaktzonen (Z1, Z'1, Z2, Z3, Z'3) zusammenwirken, die auf einer Seite (2a) des Substrats angeordnet sind, wobei mindestens eine Anschlussfläche (P1, P'1) des Bauteils eine erste vertikale Anschlussflächenstruktur aufweist, die mittels eines ersten Lotmaterials (S) an eine entsprechende Kontaktzone (Z1, Z'1) des Substrats geltet ist, weiche eine erste vertikale Kontaktzonenstruktur aufweist, **dadurch gekennzeichnet, dass** mindestens eine weitere Anschlussfläche (P2) des Bauteils mit einer elektrischen Funktion eine zweite vertikale Anschlussflächenstruktur aufweist und mit einer entsprechenden Kontaktzone (Z2) des Substrats gebondet wird, die eine zweite vertikale Kontaktzonenstrtiktur aufweist, wobei die Anschlussfläche(n) und Zone(n) (P2, Z2), die jeweils diese zweiten Anschlussflächen- und Zonenstrukturen aufweisen, jeweils mit zweiten Lotmaterialien (S1, S2) überzogen sind, von denen jedes eine höhere Schmelztemperatur aufweist als diejenige des ersten Lotmaterials; wobei diese zweiten Materialien dafür geeignet sind, direkt durch Thermokompression mit einer Fügetemperatur gebondet zu werden, die zwischen der Schmelztemperatur des ersten Lotmaterials (S) und derjenigen der zweiten Lotmaterialien (S1, S2) liegt, wobei die Anschlussfläche(n) und Kontaktzone(n) (P1, Z1), die jeweils die ersten Anschlussflächen- und Zonenstrukturen aufweisen, Abmessungen von der Art aufweisen, dass ihre Lötverbindung(en) durch Schmelzen des ersten Lotmaterials bei der genannten Fügetemepratur eine resultierende gegenseitige Anziehungskraft zwischen dem Bauteil und dem Substrat erzeugt (erzeugen), welche das Thermokompressionsbonden der Anschlussfläche(n) und Kontaktzone(n) (P2, 22) sicherstellt, die jeweils die zweiten Anschlussflächen- und Zonenstrukturen aufweisen.

10. Modul nach Anspruch 9, **dadurch gekennzeichnet, dass** das aktive Bauteil (1) ein optoelektronisches Bauteil vom Typ einer Photodiode oder eines mit Elektroabsorption arbeitenden elektrooptiscben Modulators oder einer Laserquelle mit direkter Modulationssteuerung ist.
